Europäisches Patentamt

European Patent Office

Office européen des brevets

(19)

(11) Publication number: **0 160 484**
**A2**

(12) # EUROPEAN PATENT APPLICATION

(21) Application number: **85302802.5**

(22) Date of filing: **22.04.85**

(51) Int. Cl.⁴: **H 03 D 3/24**
**H 03 L 7/08**

(30) Priority: **23.04.84 JP 81602/84**

(43) Date of publication of application:
**06.11.85 Bulletin 85/45**

(84) Designated Contracting States:
**DE FR GB NL**

(71) Applicant: **NEC CORPORATION**
**33-1, Shiba 5-chome, Minato-ku**
**Tokyo 108(JP)**

(72) Inventor: **Matsuo, Yoshio**
**c/o NEC Corporation 33-1, Shiba 5-chome**
**Minato-ku Tokyo(JP)**

(74) Representative: **Orchard, Oliver John**
**JOHN ORCHARD & CO. Staple Inn Buildings North High**
**Holborn**
**London WC1V 7PZ(GB)**

(54) FM receiver including a baseband PLL circuit.

(57) An FM receiver comprises a complex detector for complex detecting an FM signal by using, as a reference signal, a local oscillator signal having a frequency substantially equal to the carrier frequency of the FM signal; a first low-pass filter for filtering out the real part of the complex output signal from the complex detector; a second low-pass filter for filtering out the imaginary part of the complex signal; a complex voltage-controlled oscillator operating in the positive and negative frequency ranges including the zero frequency and being frequency controllable with a frequency control signal; an operational circuit for taking out one of the imagery and the real part signals of the product of the output complex conjugate signal from the complex voltage-contolled oscillator and the filtered complex signals from the first and second low-pass filters; and a third low-pass filter for filtering the output of the operational circuit to provide a demodulated output and to feed the same back as the frequency control signal to the complex voltage-controlled oscillator.

FIG.1.

FM Receiver Including A Baseband PLL Circuit

Background of the Invention

The present invention relates to generally an FM receiving circuit for use in a radio communication system and, more particularly, to an FM receiver including an improved baseband phase locked loop (PLL) circuit.

A conventional FM receiver is either of direct detection or of superheterodyne type. The direct detection type is defective in that it is difficult to obtain sufficient selectivity because the frequency selectivity is dependent on filters of the high-frequency bands. Since, in the superheterodyne type, a high-frequency input signal is converted into an intermediate frequency signal, and the frequency selectivity is determined by an intermediate frequency filter, better selectivity is achieved, compared with the direct detection type. However, in the process of frequency conversion, the FM receiver tends to become sensitive to a frequency (an image frequency) which is apart from the frequency to be received by two times the intermediate frequency. In order to eliminate the component of the image frequency, a band-pass filter has to be provided between the high-frequency input terminal and the frequency conversion circuit. The use of the band-pass filter induces a loss of a receiving power. Moreover, when a receiving frequency is changed, the filter has to be changed, too. Such defects become more aggravating as the range of frequency to be received becomes wider. Providing a high-frequency filter or an intermediate-frequency filter has a problem in realizing higher integration of circuits.

Summary of the Invention

An object of the present invention is, therefore, to provide an FM receiver having a better selectivity, a wider range of frequency coverage, and higher integration.

Another object of the invention is to provide an FM receiver directly converting an input signal to a baseband signal of about zero frequency by using a local oscillator signal of frequency substantially equal to the carrier frequency of the input signal.

Further object of the invention is to provide an FM receiver in which only low-pass filters are used to obtain high frequency selectivity.

According to the present invention, there is provided with an FM receiver for receiving an FM signal comprising: a complex detector for complex detecting the FM signal by using a local oscillator signal having a frequency substantially equal to the carrier frequency of the FM signal as a reference signal; a first low-pass filter for filtering the real part signal of the output complex signal from the complex detector; a second low-pass filter filtering the imaginary part signal of the complex signals; a complex voltage-controlled oscillator operating both in the positive and the negative frequency ranges including the zero frequency and being frequency-controllable with a frequency control signal; an operational circuit for taking out one of an imaginary part and a real part signals of a product of an output complex conjugate signal from the complex voltage-controlled oscillator and the filtered complex signals from the first and second low-pass filters; and a third low-pass filter for filtering the output of the operational circuit to provide a demodulated output and to feed it back as the frequency control signal to the complex voltage-controlled oscillator.

Brief Description of the Drawing

These and other objects, features and advantages of the present invention will become more apparent from the following description made in conjunction with the accompanying drawings, in which

Fig. 1 is a schematic block diagram of the FM receiver of one embodiment according to the present invention; and

Fig. 2 is a schematic block diagram of the complex voltage-controlled oscillator for use in the FM receiver shown in Fig. 1.

Detailed Description of the Preferred Embodiment

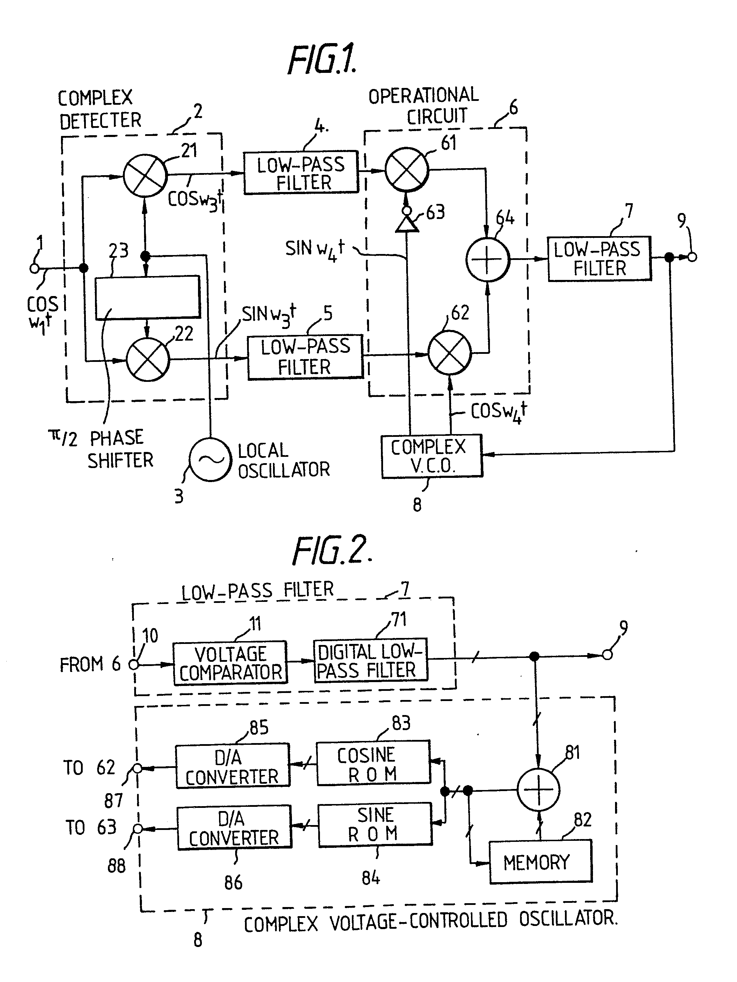

Referring to Fig. 1, the reference number 1 denotes an input terminal and 2 a complex detector which comprises product detectors 21 and 22 and a $\pi/2$ phase shifter 23. The reference number 3 denotes a local oscillator which generates a signal of frequency substantially equal to the carrier frequency of an input signal to be applied to the terminal 1, 4 a first low-pass filter (LPF), 5 a second LPF and 6 an operational circuit which comprises multipliers 61 and 62, an inverter 63 and an adder 64. The reference number 7 denotes a third LPF, 8 a complex voltage-controlled oscillator (VCO), and 9 an output terminal. It is expressed herein that an input signal to be fed to the input terminal 1 is $\cos\omega_1 t$ (provided that $\omega_1 = 2\pi f_1$, wherein $f_1$ is the frequency of the input signal) and the output signal of the local oscillator 3 is $\cos\omega_2 t$ (provided that $\omega_2 = 2\pi f_2$, wherein $f_2$ is the local oscillation frequency). It should be noted that $\omega_1$ and $\omega_2$ denote each angular frequency (or angular velocity) and $\underline{t}$ time. Coefficients are omitted in both (the same applies hereinafter).

The angular velocity $\omega_2$ of the output signal from the local oscillator 3 is preferably made coincide with but not necessarily synchronized with the angular velocity $\omega_1$ of the input signal. In the output of the

- 5 -

0160484

product detector 21, the low frequency component $\cos\omega_3 t$ (wherein $\omega_3 = \omega_1 - \omega_2$) of the product of $\cos\omega_1 t$ and $\cos\omega_2 t$ is obtained. Likewise in the output of the product detector 22, the low frequency component $\sin\omega_3 t$ of the product of $\cos\omega_1 t$ and $\cos(\omega_2 t + \pi/2)$ is obtained. By regarding these outputs as representing the real part and the imaginary part respectively, the complex detection output $\cos\omega_3 t + j\sin\omega_3 t$ is obtained (wherein $\underline{j}$ denotes a unit of imaginary number). The complex detection output is restricted in band as it passes through the first LPF 4 and the second LPF 5.

Assuming a frequency $f_3$ which is $\omega_3 = 2\pi f_3$ and the band width B for the LPFs 4 and 5, then the filters operate to allow the signals pass only when $f_3 < B$, or when $|f_1 - f_2| < B$. In other words, the LPFs 4 and 5 have the frequency selectivity which is sensitive only when $f_1$ is within the range of $\pm$ B from $f_2$. The low-pass filters may have precipitious cutoff characteristics and, therefore, a very steep selectivity can be obtained irrespective of the center frequency $f_2$. The complex detection output signals which have passed through the LPFs 4 and 5 will be processed with the output signal of the complex VCO 8 in the operational circuit 6.

If the output of the complex VCO 8 is assumed as $\cos\omega_4 t + j\sin\omega_4 t$ in this embodiment, the process of the operational circuit 6 will be conducted in such a way to take out the imaginary part of the complex multiplication between the complex conjugate number of the output of the oscillator 8 and complex detection output signal. The inverter 63 inverts the polarity of $\sin\omega_4 t$ in order to form a complex conjugation. The multiplier 61 multiplies $\cos\omega_3 t$ with $-\sin\omega_4 t$, and the multiplier 62 multiplies $\sin\omega_3 t$ with $\cos\omega_4 t$. From the output of the adder 64, $\sin(\omega_3 - \omega_4)t$ is obtained by simplifying the following formular:

$$\sin\omega_3 t \ X \ \cos\omega_4 t \ - \ \cos\omega_3 t \ X \ \sin\omega_4 t$$

This signal is outputted to the output terminal 9 via the third LPF 7 and also fed back to the frequency control terminal of the complex VCO 8. If $\omega_3$ and $\omega_4$ are assumed to be sufficiencly in approximation with each other, as the term, $(\omega_3 - \omega_4)t$ changes slowly, it can quasi-statically be treated as a phase $\theta$. When the phase $\theta$ is in the range of 0° to 180°, the feedback voltage becomes positive. If the oscillation frequency of the complex VCO 8 is controlled to increase at this point, $\omega_4$ increases and $\theta$ decreases; i.e., the output of the adder 64 changes toward zero. On the other hand, when $\theta$ is in the range of 180° to 360°, the feedback voltage becomes negative, and $\omega_4$ decreases and $\theta$ increases; i.e., the output of the adder 64 also changes toward zero.

Thus, whenever there exists a difference between $\omega_3$ and $\omega_4$, it functions as a phase locked loop (PLL) circuit which is controlled to decrease the difference and to satisfy the equation, $\omega_3 - \omega_4 = 0$.

The PLL circuit of the present invention differs from the conventional one in that it is intended to synchronize the complex signals, to have the merit that it is capable of operating even when $\omega_3$ and $\omega_4$ are in the negative range. The fact that $\omega_4$ changes in correspondence with $\omega_3$ means, as is evident from the relation $\omega_3 = \omega_1 - \omega_2$, that $\omega_4$ also changes in correspondence with $\omega_1$. When the input signal is frequency-modulated (e.i., FM signal), as $\omega_1$ changes in proportion to the modulation signal, $\omega_4$ changes in proportion to the modulation signal. In so far as the PLL circuit is synchronized at this point, the voltage for controlling the complex VCO will change in proporation to the modulation signal. The signal can be taken out from the output terminal 9 as a demodulated signal. The FM signal may include an frequency shift keyed (FSK) signal.

The relationship between the input of the LPF 7 and the output of the LPF 7 when the PLL circuit is in a phase locked condition will now be explained. Generally, an LPF used in the loop of a PLL circuit includes an integrator. If the integrator is an ideal integrator without leakage, the filter output increases/decreases in correspondence to the polarity of the filter input until the filter input becomes zero and the output voltage of the filter continues to change until the frequency $\omega_4$ of the VCO 8 becomes equal to $\omega_3$. Once the relationship of $\omega_4 = \omega_3$ is attained, the output of the adder 64 becomes zero, whereby the filter output stops changing to retain the voltage at a value to maintain the relationship $\omega_4 = \omega_3$. In other words, if the VCO 8 is so designed that $\omega_4$ changes in proportion to the control voltage thereto, then the control voltage, or the voltage at the terminal 9 will change in proportion to the change in $\omega_3$. Although we have explained the integrator in the LPF 7 as an ideal leakage-free integrator, substantially equivalent operations are obtainable in an integrator having a leakage if the PLL circuit is designed to have a sufficiently large loop DC gain.

As has been described, an FM receiver having excellent selection characteristics can be obtained by the present invention without using band-pass filters. It is also evident from the foregoing that the FM receiver according to the present invention is capable of covering a wider range of frequencies by merely changing the frequency of the local oscillator 3.

Referring now to Fig. 2, the embodiment will now be described with respect to the third LPF 7 and the complex VCO 8.  In Fig. 2, the reference number 10 denotes an input terminal for signals from the operational circuit 6 (Fig. 1), 11 a comparator for judging the polarity of the input applied thereto, and 71 a digital low-pass filter which is operable when supplied with a binary signal.  The complex VCO 8 comprises an adder 81, a memory 82, a read-only memory (ROM) 83 which stores cosine waveforms, a ROM 84 which stores sine waveforms, digital/analog converters 85 and 86, a real part output terminal 87, and an imaginary part output terminal 88. The comparator 11 functions as a limiter to absorb the level change in the input signals.  The adder 81 and the memory 82 function as integrators, and when a positive input is received, the output increases and when a negative input is received, the output decreases.  It should be noted that the memory 82 and the adder 81 have a limited number of digits and perform modulo operation to return to zero when overflow occurs.  The value at which overflow occurs is made to correspond to 360° of the phase.

The output of the integrator is fed to the ROMs 83 and 84 as an address input.  The ROMs 83 and 84 use the address input as an phase input, and supply the output values of cosine and sine corresponding thereto to digital/ analog converters 85 and 86, respectively.  Then, the output values are converted into analog waveforms by the digital/analog converters 85 and 86 and outputted from the output terminals 87 and 88. The greater and positive the value of the control signal to be fed to the adder 81 is, the greater the curve of increase in the value of the integrator becomes, whereby the waveforms at the output terminals 87 and 88 show a rapid change and a signal having a higher frequency can be obtained. When the control signal fed to the adder 81 becomes zero, the output of the integrator stops changing and DC outputs can be obtained at the output terminals 87 and 88. In other words, signals of zero frequency can be obtained. When the control signal becomes negative, the output of the integrator decreases and whereby a cosine wave and a sine wave are obtained at the terminals 87 and 88, respectively. Contrary to the case where the frequency is positive, the phase relationship between the cosine and sine waves is inverted. In other words, negative frequency signals are obtained.

The embodiment has been described in the above with respect to the complex VCO. It is noted, however, that the ROM 84 storing the since waveforms can be switched for use as the ROM 83 storing the cosine waveforms by reducing the address by the angle of 90°. It is also a common practice to save the ROM capacity by making the ROM store the values in the range of from 0° to 90°
instead of all the values covering the range of from 0°
to 360° and obtain desired outputs by means of address
conversion and the output conversion.

In the above embodiment, no reference is made to
the amplifiers at various sections of the circuit but
they are a prerequisit in the normal practice. Although
the operational circuit 6 of the embodiment is so structured
to take out the imaginary part in the complex operation,
frequency detection can be similarly realized by taking
out the real part except that the phase relationship
in the phase locked condition becomes different.

According to the present invention, because high
frequency FM input signals are processed by converting
the same directly into  baseband signals, an LPF having
an excellent frequency selectivity can be used as a
frequency selection means for the input signals received.
In other words, it is possible to use an LPF having the
frequency cutoff characteristics of an extremely steep
curve than that obtained by the band-pass filter in the
high and intermediate frequency bands. Therefore, an
excellent frequency selectivity can be achieved. Further,
in the prior art it is necessary to change the frequency
passing the high frequency band-pass filter as well as
the locally oscillated frequency in order to change the

- 12 -

0160484

received frequency. Since the FM receiver of the present invention does not require a high frequency band-pass filter, there is no restriction as to the frequency range caused by such high frequency band-pass filter and the frequency can be easily changed over a wider frequency range by merely changing the frequency of the local oscillator.

Still furthermore, while integration of band-pass filter for higher and intermediate frequency bands entails various troublesome problems, the LPF can be easily integrated making the device compact and light as well as highly reliable.

## CLAIMS

1.  An FM receiver for receiving an FM signal, comprising: a complex detector for complex detecting said FM signal by using as a reference signal a locally oscillated signal having a frequency substantially equal to the carrier frequency of said FM signal; a first low-pass filter for filtering the real part signal of the output complex signal from said complex detector; a second low-pass filter for filtering the imaginary part signal of said complex signal; a complex voltage-controlled oscillator operating in the positive and negative frequency ranges including the zero frequency and being frequency controllable with a frequency control signal; an operational circuit for taking out one of the imaginary and the real part signals of the product of the output complex conjugate signal from said complex voltage-controlled oscillator and the filtered complex signals from said first and second low-pass filters; and a third low-pass filter for filtering the output of said operational circuit to provide a demodulated output and to feed the same back as said frequency control signal to said complex voltage-controlled oscillator.

2.  An FM receiver comprising: complex detection means for detecting an FM input signal with a locally oscillated signal having a frequency substantially equal to that of said FM input signal to produce a first complex detection output;

first and second low-pass filter means for respectively filtering the real part signal and the imaginary part signal of said first complex detection output;

complex voltage-controlled oscillator means for generating a complex oscillated signal and changing the frequency of said complex oscillated signal in response to a control signal;

operational means for multiplying the outputs of said first and second low-pass filters with said complex oscillated signal and extracting from the product one of the real part signal and the imaginary part signal; and

third low-pass filter means for filtering the output of said operational means to produce a demodulated signal and to supply the same as said control signal to said complex voltage-controlled oscillator means.

3. An FM receiver as claimed in Claim 2, wherein said third low-pass filter further comprises comparator means for comparing the output of said operational means with a reference voltage to produce a digital signal; and digital low-pass filter means for digitally filtering said digital signal.

4.   An FM receiver as claimed in Claim 3, wherein said complex voltage-controlled oscillator means comprises means for integrating the output of said digital low-pass filter means to produce a digital integrated signal; and waveform generating means for outputting a cosine and a sine waveform in response to said digital integrated signal.

5.   An FM receiver as claimed in Claim 4, wherein said waveform generating means comprises first and second memory means for outputting said cosine and sine waveforms in digit values in response to said digital integrated signal; and first and second digital/analog converter means for converting the digital outputs of said first and second memory means into analog signals.

6.   A method for receiving and demodulating a frequency-modulated carrier wave comprising the steps of:
    complex-detecting said carrier wave  with a signal of frequency substantially identical to the frequency of the carrier wave;
    low-pass filtering the complex detected signals; and
    synchronously detecting the filtered signals with a complex signal to provide a demodulated output.

7.   A method as claimed in Claim 6, wherein said step of synchronously detecting further comprises the steps of:

multiplying the low-pass filtered signal with said complex signal;

extracting one of the real part signal and the imaginary part signal of the multiplied signal;

low-pass filtering the extracted signal to produce said demodulated output; and

generating said complex signal in response to said demodulated output.

## FIG.1.

COMPLEX DETECTER 2

OPERATIONAL CIRCUIT 6

21 — $COSw_3t$

LOW-PASS FILTER 4.

61

63

$SIN w_4t$

64

LOW-PASS FILTER 7

9

1

23

$COS w_1t$

22 — $SINw_3t$

LOW-PASS FILTER 5

62

$COSw_4t$

$\pi/2$ PHASE SHIFTER

LOCAL OSCILLATOR 3

COMPLEX V.C.O. 8

## FIG.2.

LOW-PASS FILTER 7

FROM 6 — 10

VOLTAGE COMPARATOR 11

DIGITAL LOW-PASS FILTER 71

9

TO 62 — 87

D/A CONVERTER 85

COSINE R O M 83

81

TO 63 — 88

D/A CONVERTER 86

SINE R O M 84

82

MEMORY

COMPLEX VOLTAGE-CONTROLLED OSCILLATOR.

8